# EUROPÄISCHE PATENTSCHRIFT

(11) **EP 1 026 532 B1**
(45) Veröffentlichungstag und Bekanntmachung des Hinweises auf die Patenterteilung: **17.09.2003**
(21) Anmeldenummer: 00101031.3
(22) Anmeldetag: 20.01.2000
(51) Int. Cl.: G02B 7/02

(54) **Baugruppe aus einem optischen Element und einer Fassung**
Assembly comprising an optical element and an optical mount
Ensemble comportant un élément optique et sa monture

(30) Priorität: 03.02.1999 DE 19904152
(43) Veröffentlichungstag der Anmeldung: 09.08.2000
(73) Patentinhaber: Carl Zeiss, 89518 Heidenheim (Brenz) (DE); Carl-Zeiss-Stiftung, trading as Carl Zeiss, 89518 Heidenheim (Brenz) (DE)
(72) Erfinder: Trunz, Michael, 73479 Ellwangen (DE); Hilgers, Ralf, 73434 Aalen (DE); Gellrich, Bernhard, 73434 Aalen (DE)
(74) Vertreter: Lorenz, Werner, Dr.-Ing.

(56) Entgegenhaltungen:
- DE-A- 19 632 265
- DE-B- 1 262 041
- US-A- 2 808 762
- PATENT ABSTRACTS OF JAPAN vol. 007, no. 188 (P-217), 17. August 1983 (1983-08-17) & JP 58 087504 A (OLYMPUS KOGAKU KOGYO KK), 25. Mai 1983 (1983-05-25)

## Beschreibung

Die Erfindung betrifft eine Baugruppe aus einem optischen Element und einer Fassung nach der im Oberbegriff von Anspruch 1 näher definierten Art.

Baugruppen dieser Art, insbesondere Objektive mit Linsen als optisches Element, wobei die Verbindung der Linse mit einer diese umgebende Fassung über elastische Verbindungsglieder erfolgt, sind allgemein bekannt.

Die US 5,428,482 bezieht sich auf die Entkopplung eines optischen Elementes von einer Fassung durch elastische balkenartige Verbindungsglieder zwischen dem optischen Element und der Fassung.

Die EP 0 230 277 A2 betrifft eine Präzisionslinsenbefestigung, wobei ebenfalls elastische Biegeelemente in Form von Balken zwischen dem optischen Element und der Fassung vorgesehen sind. Durch die elastischen Biegeelemente soll eine radiale Nachgiebigkeit zum Ausgleich von Wärmespannungen möglich werden.

Ähnliches gilt für die EP 0 243 893 B1, in der eine Linsenbefestigung für Positionslinsen beschrieben ist, wobei eine Vielzahl von Biegeeinrichtungen, die blattfederartig ausgebildet sind, eine Linse als optisches Element an einer Fassung hält.

Zum allgemeinen Stand der Technik sei außerdem auf die DE-B-1 262 041 verwiesen, welche eine Fassung zeigt, bei der ein optisches Element, hier eine Linse, an einer steifen und ringförmigen Anlagefläche als Linsensitz anliegt und von einem Festlegering gehalten wird. Der Festlegering stützt sich dabei über axial wirkende Federelemente an einem in axialer Richtung gegen die Federkraft des Festlegerings festsitzenden Sprengring ab, so daß die Linse gegen den Linsensitz gepreßt und in ihrer Position gehalten wird.

Dies stellt eine einfache und sichere Möglichkeit der Befestigung einer Linse dar, welche aufgrund der direkten Anlage der Linse an einem steifen und ringförmigen Linsensitz in der Fassung jedoch keinerlei Elastizität aufweist, so daß eine Deformationsentkoppelung zwischen der Linse und der Fassung nicht realisiert werden kann.

Der vorliegenden Erfindung liegt die Aufgabe zugrunde, eine Verbindungstechnik zwischen einem optischen Element und einer dieses haltende Fassung zu schaffen, wobei das optische Element derart über elastische Anbindungen mit der Fassung verbunden ist, daß eine wenigstens weitgehende Spannungsfreiheit oder Spannungsarmut und damit eine Verringerung der Oberflächendeformation des optischen Elementes bei einer geometrisch einfachen Ausgestaltung geschaffen wird.

Erfindungsgemäß wird diese Aufgabe durch die im kennzeichnenden Teil von Anspruch 1 genannten Merkmale gelöst.

Durch die Verbindung mittels des membranartigen Fügeelementes über eine steife, ein Moment übertragende Verbindung können Spannungsdifferenzen abgebaut werden bzw. treten diese bei der Montage nicht mehr auf. Dies bedeutet auch, Deformationen oder Toleranzungenauigkeiten des Flansches wirken sich nicht auf das optische Element, z.B. eine Linse, aus.

Durch das erfindungsgemäße membranartige Fügeelement wird bei der Montage eine hohe Elastizität bzw. Nachgiebigkeit in z-Richtung, d.h. in Richtung der optischen Achse, erreicht. Auf diese Weise läßt sich das optische Element spannungsarm exakt auf dem Fügeelement ausrichten. Wird anschließend eine feste Verbindung zwischen dem Fügeelement und dem optischen Element hergestellt und zwar erfindungsgemäß eine steife, ein Moment übertragende Verbindung, so wird praktisch der sich dabei einstellende Biege-Winkel zwischen dem Fügeelement und dem optischen Element festgehalten, womit sich nicht ohne weiteres eine weitere Verbiegung bei einer auftretenden Belastung einstellen kann, d.h. Winkeländerungen sind nicht mehr möglich. Durch die Herstellung einer festen Verbindung werden an der Verbindungsstelle die Momentenfreiheitsgrade gesperrt. Damit liegt bei auftretenden äußeren Kräften und Momenten eine Beulbeanspruchung vor, deren Steifigkeit wesentlich größer ist, als die der reinen Biegung, wodurch die erforderliche Eigenfrequenz und Stabilität gesichert wird.

Eine einfache konstruktive Ausgestaltung zur Lösung der gestellten Aufgabe kann darin bestehen, daß das Fügeelement aus einem Membranring oder mehreren Ringsegmenten besteht, die zu einem geschlossenen Membranring zusammengesetzt werden. Auf diese Weise wird eine deutliche Reduktion von Oberflächendeformationen des optischen Elementes erreicht.

Vorteilhafte Weiterbildungen und Ausgestaltungen der Erfindung ergeben sich aus den Unteransprüchen und aus dem nachfolgend anhand der Zeichnung prinzipmäßig beschriebenen Ausführungsbeispiel.

Es zeigt:
- Figur 1: ausschnittsweise einen Schnitt durch eine Baugruppe mit einer Fassung und einer Linse als optischem Element,
- Figur 2: ausschnittsweise eine Draufsicht auf ein membranartiges Fügeelement mit Laschen,
- Figur 3: eine weitere Ausgestaltung eines membranartigen Fügeelementes in der Draufsicht (ausschnittsweise),
- Figur 4: eine Draufsicht auf eine dritte Ausgestaltung eines membranartigen Fügeelementes,
- Figur 5: ausschnittsweise einen Schnitt durch eine weitere Ausgestaltung einer Baugruppe mit einer Fassung und einem optischen Element,
- Figur 6: ausschnittsweise einen Schnitt durch eine dritte Ausgestaltung einer Baugruppe mit einer Fassung und einer Linse als optischem Element in horizontaler Anordnung der Linse,
- Figur 7 bis 11: verschiedene Ausgestaltungen von Laschen eines Membranringes als Fügeelement.

Eine ringförmige Fassung 1 ist auf der Innenseite mit einem Ringabsatz 2 versehen, der eine wenigstens annähernd der Biegelinie eines Fügeelementes 4 entsprechend verlaufende Auflagekontur 3 aufweist. Auf die Auflagekontur 3 wird als Fügeelement ein Membranring 4 aufgelegt und form- und/oder kraftschlüssig (z.B. durch Schweißen, Löten oder Kleben) fest mit der Fassung 1 verbunden. Zur genauen Zentrierung und als Anschlag dient dabei ein Zentrierbund 5 am hinteren Ende der Auflagekontur 3. Von dem Membranring 4 aus ragen von seinem Innenumfang aus eine Vielzahl von Laschen 6 nach innen. Die Laschen 6 dienen als Auflage für eine Linse 7 als optisches Element. Der Membranring 4 mit den Laschen 6 ist aus einem federnden Material, z.B. einem sehr dünnen Blech mit einer Stärke von 0,3 bis 0,5 mm hergestellt. Die einstückig mit dem Membranring 4 verbundenen Laschen können dabei eine noch dünnere Dicke von z.B. 0,1 bis 0,3 mm aufweisen.

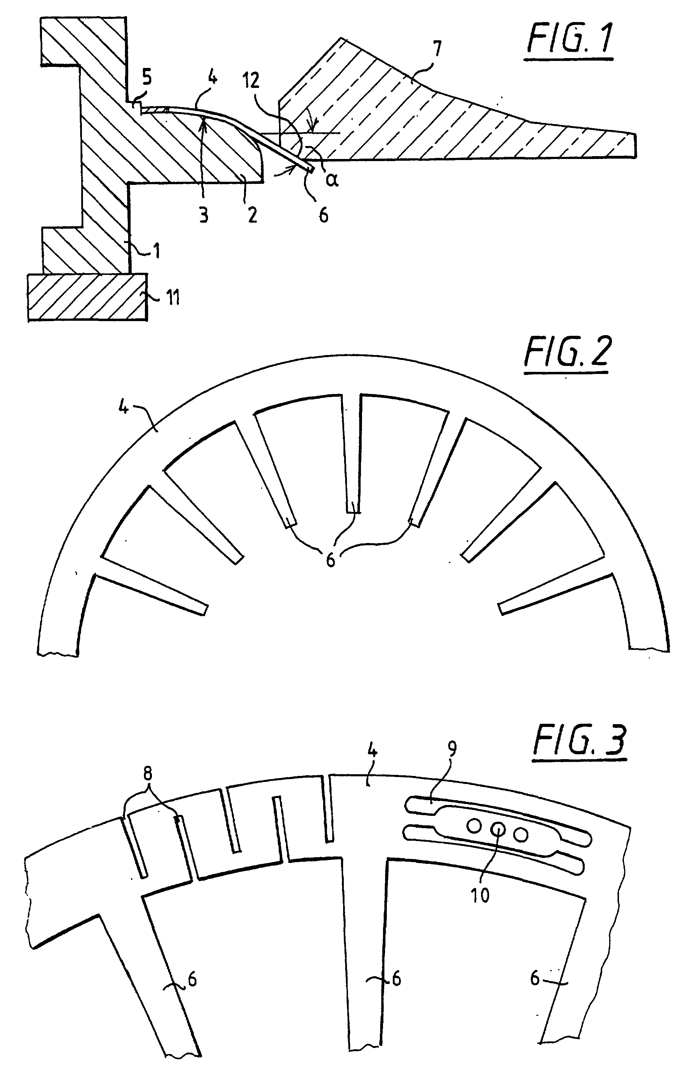

Als Bleche für den Membranring 4 mit den Laschen 6 können z.B. kaltgewalzte Bänder aus Edelstahl, Titanlegierungen oder Nitinol-Nickel-Titan-Legierungen, die auch als Memory-Legierung bezeichnet werden, verwendet werden. Insbesondere eine Legierung mit superelastischen Eigenschaften ist für den vorgesehenen Zweck geeignet, da diese Legierungen große Deformationen auf kleinem Bauraum ermöglichen. Das Fügeelement, d.h. der Membranring 4, kann auch mit der Integration oder Applikation eines intelligenten Werkstoffes (smart materials, z.B. Formgedächtnis - oder piezoelektrische Elemente) versehen sein, so daß durch Energiezufuhr die Beeinflussung des Deformationszustandes des optischen Elementes möglich ist, bzw. dieser erfaßt werden kann. Der Membranring kann durch eine Ätztechnik hergestellt werden, was insbesondere dann von Vorteil ist, wenn er mit zahlreichen Konturen versehen ist, wie z.B. aus der Figur 3 ersichtlich.

Die Figur 3 zeigt einen Membranring 4 mit Laschen 6, wobei in dem Membranring 4 vom Außenumfang her und vom Innenumfang her abwechselnd radial oder tangential verlaufende Schlitze 8 eingeformt sind. Die Schlitze 8 dienen dazu, einen Verzug des Membranringes 4 zu vermeiden, wenn dieser z.B. durch Schweißen mit den daraus resultierenden Spannungen mit der Fassung 1 verbunden wird. Alternativ oder auch zusätzlich dazu kann der Membranring 4 auch mit über den Umfang verteilt angeordneten Entlastungstaschen 9 versehen sein. Die Entlastungstaschen 9 können beliebig ausgebildet sein mit z.B. in Umfangsrichtung verlaufenden Nuten unterschiedlichen Querschnittes und mit zwischen den Nuten liegenden Entlastungsbohrungen 10.

Der Zusammenbau der optischen Baugruppe kann auf einfache Weise und sehr präzise bezüglich der Positionierung der Linse 7 erfolgen. In einem ersten Schritt wird die Fassung 1 auf einen steifen ebenen Gegenflansch 11 aufgespannt. Anschließend wird der Membranring 4 an der Auflagekontur 3 z.B. durch Schweißen befestigt. In einem nächsten Schritt wird die Linse 7 auf die Laschen 6 aufgelegt und in einem bekannten Richtfügevorgang, ausgerichtet. Ist der Richtfügevorgang beendet, wobei aufgrund der hohen Elastizität des Membranringes 4 bzw. der Laschen 6 eine spannungs- und deformationsfreie Auflage der Linse 7 erreicht werden kann, erfolgt z.B. über Kleben oder Löten an einer Verbindung 12 eine steife Verbindung zwischen der Linse 7 und dem Membranring 4 bzw. dessen Laschen 6.

Durch die auf diese Weise hergestellte Verbindung 12, die damit auch Momente übertragen kann, erhält der Membranring 4 mit den Laschen 6 eine hohe Steifigkeit und zwar aufgrund der gebogenen geometrischen Form nach der festen Verbindung mit der Linse. Es stellt sich praktisch ein fester Winkel α im Bereich der Verbindung 12 ein, der sich nicht mehr verändern kann. Dadurch daß sich der Winkel α nicht mehr ändern kann besteht bei einem Auftreten von Kräften für den Membranring 4 bzw. den Lamellen 6 nur die Möglichkeit einer geringfügigen S-förmigen Verbiegung bzw. Beulung. Auf diese Weise ist erreicht worden, daß bei der Montage eine sehr große Deformation möglich, aber nach dem Fügevorgang eine hohe Steifigkeit gegeben ist, so daß eine Positionierung der Linse 7 mit einer ausreichenden Genauigkeit und Stabilität erreicht wird.

Die geometrische Gestaltung des Fügeelementes, z.B. als Membranring 4 mit Laschen 6 kann in Abhängigkeit vom Anwendungsfall in einem hohen Maße variiert werden. So kann z.B. die geometrische Gestaltung des Membranringes 4 einmal definiert werden und dann für ein Objektiv in seiner Gesamtheit gleich bleiben. Es ist dann lediglich nötig, die erforderlichen Durchmesser den Linsen anzupassen. Die Anzahl und die Form der Laschen 6 ist von der Linsenmasse und der Blechdicke abhängig und läßt sich ebenfalls variieren. Gleiches gilt für den Membranring 4, der als geschlossener Ring ausgebildet sein kann, mit Schlitzen versehen, wie z.B. die Schlitze 8 oder auch aus Einzelsegmenten, z.B. 90°-Winkelsegmenten gebildet sein.

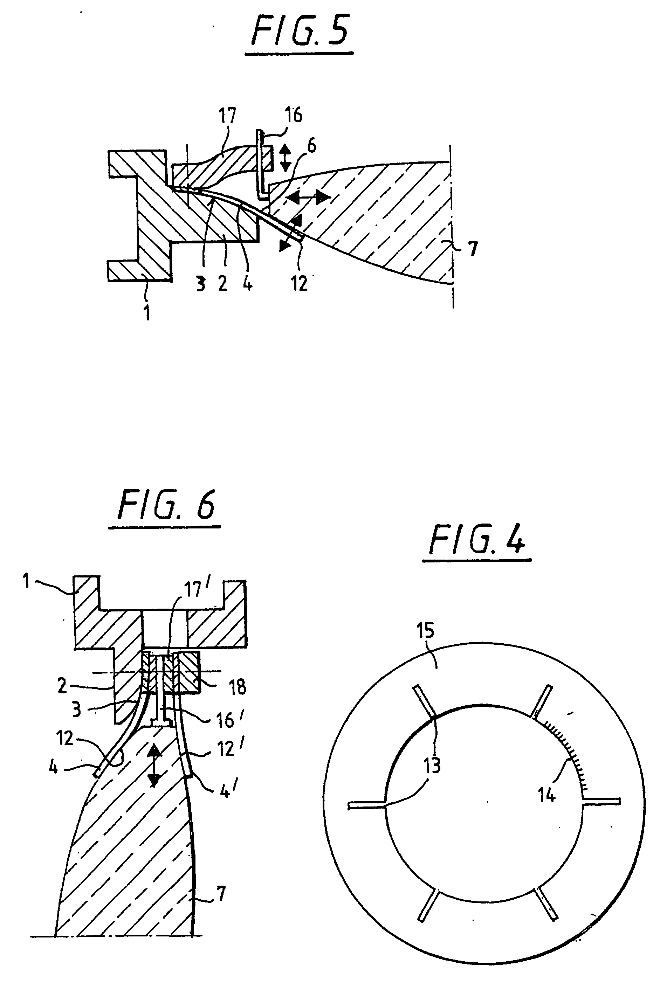

Insbesondere eine Herstellung aus mehreren Einzelsegmenten bietet sich dann an, wenn man eine sehr hohe Präzision erreichen möchte und unterschiedliche Elastizitäten aufgrund der bekannten Anisotopie von gewalzten Blechen, die zu einer ungleichmäßigen Durchbiegung des Membranringes 4 und/oder der Laschen 6 führt, vermieden werden soll. In der Figur 4 ist hierzu ein Membranring 4 dargestellt, der beispielsweise mit nur 6 Einschnitten 13 versehen ist, wodurch nur 6 laschenartige Auflageflächen für die Linse 7 gebildet werden. Zusätzlich können noch zur Erhöhung der Elastizität zwischen den Einschnitten 13 vom Innenumfang her aus eine Vielzahl von kürzeren Einschnitten 14 vorgesehen werden. Gestrichelt ist in der Figur 4 auch angedeutet, daß der Membranring 4 aus 4 Einzelsegmenten 15 gebildet sein kann.

Falls noch eine höhere Steifigkeit in z-Richtung, d.h. in Richtung der optischen Achse, erreicht werden soll, so kann noch eine kraftfreie Zentrierung der Linse 7 über Stifte 16 erfolgen. Die Stifte 16 sind in über den Umfang verteilt und mit ihren Längsachsen in z-Richtung angeordneten Bohrungen eines Stützringes 17 eingesetzt. Der Stützring 17 ist im äußeren Bereich mit der Fassung 1, z.B. durch Schrauben verbunden. Gleichzeitig kann diese Verbindungsart auch die Befestigung des Membranringes 4 mit der Fassung bilden.

Die Stifte 16 besitzen eine L-Form, wobei sich dessen abgewinkelter Teil rechtwinklig zur z-Achse erstreckt und mit dem freien Ende z.B. durch Kleben mit der Umfangswand der Linse 7 verbunden ist. Sobald die Linse 7 in z-Richtung ausgerichtet ist, werden die Stifte 16 in den Bohrungen des Stützringes 17 in ihren Lagen fixiert, was z.B. dadurch erfolgen kann, daß in die Bohrungen Klebstoff eingebracht wird.

Die in der Figur 5 dargestellte Steifigkeitserhöhung in z-Richtung ist für eine Baugruppe vorgesehen, die vertikal angeordnet ist.

Die Figur 6 zeigt eine Anordnung, wobei die Linse 7 vertikal angeordnet ist und sich die z-Achse horizontal erstreckt. Aus diesem Grunde ist zusätzlich zu dem Membranring 4 als Fügeelement ein zweiter Membranring 4' vorgesehen, der auf der dem Membranring 4 gegenüberliegenden Seite der Linse 7 ebenfalls über eine steife, ein Moment übertragende Verbindung 12' mit der Linse verbunden ist. Auch bei diesem Ausführungsbeispiel sind Zentrierglieder in Form von Stiften 16' vorgesehen, die über den Umfang verteilt am Außenumfang der Linse 7 angreifen. In diesem Falle besitzen die Stifte 16' eine umgekehrte T-Form und sind über die T-Balken am Umfang der Linse 7 festgeklebt. Die Stifte 16' sind wiederum in Bohrungen eines Stützringes 17' eingesetzt, welche nach der Ausrichtung der Linse 7 mit einem Klebstoff zur Herstellung einer festen Verbindung zwischen den Stiften 16' und dem Stützring 17' ausgefüllt werden.

Zur Befestigung des zweiten Membranringes 4', der ebenfalls mit Laschen 6 versehen sein kann, dient ein Haltering 18, durch den der Membranring 4' gleichzeitig mit dem Stützring 17' und dem Membranring 4 fest mit der Fassung 1 verbunden ist.

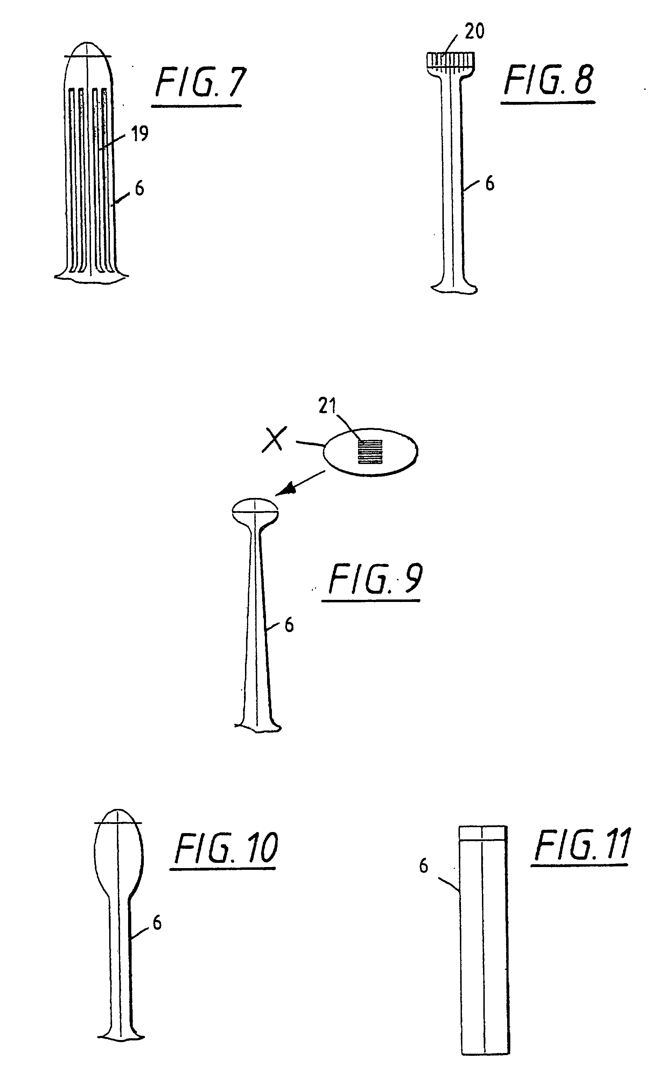

In den Figuren 7 bis 11 sind beispielsweise verschiedene Arten von Laschen 6 des Membranringes 4 bzw. 4' dargestellt.

Figur 7 zeigt dabei eine Form, in welcher die Lasche in Längsrichtung mit einer Struktur 19 versehen ist.

Figur 8 zeigt im Bereich der Verbindung 12 mit der Linse 7 eine Kammstruktur bzw. Einschnitte 20. Gleichzeitig zeigt die Figur 8 auch eine Ausgestaltung einer Lasche 6 mit einem Bereich einer reduzierten Breite zwischen dem Membranring 4 und der Verbindung 12 im vorderen Bereich.

Figur 9 zeigt eine noch größere Einschnürung einer Lasche 6 mit konischem Verlauf zu dessen vorderem Ende, das als Verbindung 12 mit der Linse 7 dient. In der Ausschnittsvergrößerung X auf der Extrafläche ist angedeutet, daß das vordere Ende der in der Figur 9 dargestellten Lasche 6 im Bereich der Verbindung 12 mit der Linse 7 mit einer geätzten Gitterstruktur 21 versehen sein kann. Die geätzte Gitterstruktur 21 hat die Aufgabe, eine bessere Verklebung an der Verbindung 12 zu erreichen bzw. damit ist es nicht erforderlich den Kleber extrem genau dosieren zu müssen, da dieser dann in die Gitterstruktur 21 ausweichen kann. Selbstverständlich ist eine derartige Gitterstruktur 21 auch bei anderen Laschenformen möglich.

Die Figur 10 zeigt eine ähnliche Ausgestaltung einer Lasche 6 wie die Figur 9, wobei lediglich der eingeschnürte Bereich nicht so stark hervorgehoben ist und der Auflagebereich zur Verbindung 12 eine angenäherte Ellipsenform aufweist mit einer in radialer Richtung verlaufenden größeren Ellipsenachse.

Die Figur 11 zeigt eine einfache rechteckige Ausgestaltung (ebenfalls in der Draufsicht) einer Lasche 6. Während man z.B. breite Laschen, wie die in der Figur 7 und 11 dargestellten Laschen 6, mit einer dünneren Blechdicke, wie z.B. 0,1 bis 0,3 mm, herstellen wird, wird man schmale lange Laschen 6 mit einer größeren Blechdicke, z.B. 0,3 bis 0,5 mm, herstellen.

## Patentansprüche

1. Baugruppe aus einem optischen Element und einer Fassung, bei der das optische Element über elastische Verbindungsglieder direkt oder über ein oder mehrere Zwischenglieder mit der Fassung verbunden ist, so daß keine steife und ringförmige Auflagefläche zwischen dem optischen Element und der Fassung selbst ausgebildet ist, **dadurch gekennzeichnet, daß** das oder die Verbindungsglieder wenigstens ein membranartiges Fügeelement (4) aufweist, welches im äußeren Bereich mit der Fassung (1) oder mit dem oder den Zwischengliedern und im inneren Bereich über eine steife, Momente übertragende Verbindung (12) mit dem optischen Element (7) verbunden ist.

2. Baugruppe nach Anspruch 1, **dadurch gekennzeichnet, daß** das Fügeelement einen Membranring (4) oder mehrere Membranringsegmente (15) aufweist, die zu einem geschlossenen Membranring zusammensetzbar sind.

3. Baugruppe nach Anspruch 1 oder 2, **dadurch gekennzeichnet, daß** das Fügeelement (4) am Innenumfang mit Laschen (6) versehen ist, auf denen das optische Element (7) aufliegt und über die die steife, Momente übertragende Verbindung (12) hergestellt ist.

4. Baugruppe nach einem der Ansprüche 1 bis 3, **dadurch gekennzeichnet, daß** das Fügeelement (4) aus einem dünnen federartigen Blech besteht.

5. Baugruppe nach einem der Ansprüche 1 bis 4, **dadurch gekennzeichnet, daß** die Verbindung (12) form- oder kraftschlüssig erfolgt, z.B. durch Schweißen, Löten, Kleben oder Klemmen.

6. Baugruppe nach einem der Ansprüche 1 bis 5, **dadurch gekennzeichnet, daß** das Fügeelement (4) im äußeren Umfangsbereich, in welchem es mit dem Rahmen (1) oder ein oder mehreren Zwischengliedern verbunden ist, zur Deformationsentkopplung wenigstens annähernd in radialer oder tangentialer Richtung verlaufende Schlitze (8) aufweist.

7. Baugruppe nach Anspruch 6, **dadurch gekennzeichnet, daß** sich bei Ausbildung des Fügeelementes als Membranring (4) die Schlitze (8) abwechselnd vom Außenumfang und vom Innenumfang aus erstrecken.

8. Baugruppe nach einem der Ansprüche 1 bis 7, **dadurch gekennzeichnet, daß** das Fügeelement (4) wenigstens in dem Bereich, in dem es mit der Fassung (1) oder den ein oder mehreren Zwischengliedern verbunden ist mit Entlastungstaschen (9) versehen ist.

9. Baugruppe nach einem der Ansprüche 1 bis 8, **dadurch gekennzeichnet, daß** die Fassung (1) oder ein Zwischenglied, mit welchem das Fügeelement (4) verbunden ist, im Bereich der Verbindung eine der Biegelinie des Fügeelementes entsprechende Auflagekontur (3) aufweist.

10. Baugruppe nach einem der Ansprüche 1 bis 9, **dadurch gekennzeichnet, daß** das Fügeelement (4), insbesondere bei Ausbildung mit Laschen (6), im Bereich der steifen, ein Moment übertragenden Verbindung (12), welche durch Kleben oder Löten geschaffen ist, wenigstens teilweise mit einer Gitter- (21) oder Kammstruktur (20) versehen ist.

11. Baugruppe nach einem der Ansprüche 3 bis 10, **dadurch gekennzeichnet, daß** die Laschen (6) auf ihren Oberflächen (19,20) strukturiert sind.

12. Baugruppe nach einem der Ansprüche 3 bis 11, **dadurch gekennzeichnet, daß** die Laschen (6) über ihre Länge unterschiedliche Breiten aufweisen.

13. Baugruppe nach einem der Ansprüche 1 bis 12, **dadurch gekennzeichnet, daß** das Fügeelement (4) mit der Integration oder Applikation eines intelligenten Werkstoffes (smart materials, z.B. Formgedächtnis - oder piezoelektrische Elemente) versehen ist.

14. Baugruppe nach einem der Ansprüche 1 bis 12, **dadurch gekennzeichnet, daß** das Fügeelement (4) aus einem Material mit superelastischen Eigenschaften besteht.

15. Baugruppe nach einem der Ansprüche 1 bis 14, **dadurch gekennzeichnet, daß** die Fassung (1) oder ein mit der Fassung verbundenes Glied mit einem Stützring (17) verbunden ist, aus welchem in dem Stützring (17) angeordnete Elemente (Stifte 16) ragen, die mit ihren freien Enden derart mit dem optischen Element (7) verbunden sind, daß sich eine Steifigkeitserhöhung senkrecht zur und/oder in Richtung der optischen Achse (z-Richtung) ergibt.

16. Baugruppe nach Anspruch 15, **dadurch gekennzeichnet, daß** die Elemente (Stifte 16) in Bohrungen des Stützringes (17) eingeklebt oder mit einer anderen form- oder kraftschlüssigen Verbindungstechnik befestigt sind.

17. Baugruppe nach einem der Ansprüche 1 bis 16, **dadurch gekennzeichnet, daß** das optische Element (7) durch ein zweites membranartiges Fügeelement (4'), das auf der von der Verbindung (12) mit dem ersten Fügeelement (4) abgewandten Seite angeordnet ist, über eine steife, Momente übertragende Verbindung (12'), gehalten ist.

18. Baugruppe nach einem der Ansprüche 1 bis 17, **dadurch gekennzeichnet, daß** die Fassung (1) mit einem Zentrierbund (5) für das Fügeelement (4) versehen ist.

19. Verfahren zum Verbinden eines optischen Elementes mit einer Fassung oder einem mit der Fassung verbundenen Zwischenglied, **dadurch gekennzeichnet, daß** ein membranartiges Fügeelement (4) an der Fassung (1) befestigt wird, wonach das optische Element (7) auf das Fügeelement (4) aufgelegt und durch einen Richtfügevorgang auf dem Fügeelement (4) ausgerichtet wird, wonach das optische Element (7) auf dem Fügeelement (4) durch eine steife, ein Moment übertragende Verbindung (12) fixiert wird.

20. Verfahren nach Anspruch 19, **dadurch gekennzeichnet, daß** die Fassung (1) zur Montage auf einen steifen Gegenflansch (11) aufgespannt wird.

## Claims

1. Assembly comprising an optical element and a mount, in which the optical element is connected via elastic connecting members directly or via one or more intermediate members to the mount, so that no rigid and annular supporting surface is formed between the optical element and the mount itself, **characterised in that** the connecting member or members has or have at least one membrane-like joining element (4), which in the outer region is connected to the mount (1) or to the intermediate member or members and in the inner region is connected via a rigid, moment-transmitting connection (12) to the optical element (7).

2. Assembly according to Claim 1, **characterised in that** the joining element has a membrane ring (4) or a plurality of membrane ring segments (15) which can be put together to form a closed membrane ring.

3. Assembly according to Claim 1 or 2, **characterised in that** the joining element (4) is provided on the inner circumference with tongues (6), on which the optical element (7) rests and via which the rigid, moment-transmitting connection (12) is established.

4. Assembly according to one of Claims 1 to 3, **characterised in that** the joining element (4) consists of a thin spring-like sheet metal.

5. Assembly according to one of Claims 1 to 4, **characterised in that** the connection (12) is effected in a positive or non-positive manner, for example by welding, soldering, adhesive bonding or clamping.

6. Assembly according to one of Claims 1 to 5, **characterised in that** the joining element (4) has in the outer circumferential region, in which it is connected to the frame (1) or to one or more intermediate members, slits (8) extending at least approximately in the radial or tangential direction for deformation decoupling.

7. Assembly according to Claim 6, **characterised in that**, if the joining element is designed as a membrane ring (4), the slits (8) extend alternately from the outer circumference and from the inner circumference.

8. Assembly according to one of Claims 1 to 7, **characterised in that** the joining element (4) is provided with the relief pockets (9), at least in the region in which it is connected to the mount (1) or to the one or more intermediate members.

9. Assembly according to one of Claims 1 to 8, **characterised in that** the mount (1) or an intermediate member to which the joining element (4) is connected has in the region of the connection a supporting contour (3) corresponding to the bending line of the joining element.

10. Assembly according to one of Claims 1 to 9, **characterised in that** the joining element (4), in particular when designed with tongues (6), is provided at least partly with a grid structure (21) or comb structure (20) in the region of the rigid, moment-transmitting connection (12), which is created by adhesive bonding or soldering.

11. Assembly according to one of Claims 3 to 10, **characterised in that** the tongues (6) are structured on their surfaces (19,20).

12. Assembly according to one of Claims 3 to 11, **characterised in that** the tongues (6) have different widths over their length.

13. Assembly according to one of Claims 1 to 12, **characterised in that** the joining element (4) is provided with the integration or application of an intelligent material (smart material, e.g. shape memory - or piezoelectric elements).

14. Assembly according to one of Claims 1 to 12, **characterised in that** the joining element (4) consists of a material with superelastic properties.

15. Assembly according to one of Claims 1 to 14, **characterised in that** the mount (1) or a member connected to the mount is connected to a supporting ring (17), from which there protrude elements (pins 16) which are arranged in the supporting ring (17) and are connected by their free ends to the optical element (7) in such a way that an increase in rigidity perpendicular to and/or in the direction of the optical axis (z-direction) is obtained.

16. Assembly according to Claim 15, **characterised in that** the elements (pins 16) are adhesively bonded into bores in the supporting ring (17) or are fastened by some other positive or non-positive connecting technique.

17. Assembly according to one of Claims 1 to 16, **characterised in that** the optical element (7) is held by a second membrane-like joining element (4'), which is arranged on the side facing away from the connection (12) to the first joining element (4), via a rigid, moment-transmitting connection (12').

18. Assembly according to one of Claims 1 to 17, **characterised in that** the mount (1) is provided with a centring collar (5) for the joining element (4).

19. Method of connecting an optical element to a mount or to an intermediate member connected to the mount, **characterised in that** a membrane-like joining element (4) is fastened to the mount (1), after which the optical element (7) is placed onto the joining element (4) and is aligned on the joining element (4) by a straightening and joining operation, after which the optical element (7) is fixed on the joining element (4) by a rigid, moment-transmitting connection (12) .

20. Method according to Claim 19, **characterised in that** the mount (1) is clamped onto a rigid mating flange (11) for assembly.

## Revendications

1. Sous-ensemble composé d'un élément optique et d'une monture, dans lequel l'élément optique est relié directement à la monture par des éléments de liaison élastiques ou y est relié au moyen d'un ou de plusieurs éléments intermédiaires, de sorte qu'il ne se forme aucune surface d'appui rigide et annulaire entre l'élément optique et la monture elle-même, **caractérisé en ce que** l'élément de liaison ou les éléments de liaison comportent au moins un élément de joint (4) en forme de membrane qui, dans la région extérieure, est relié à la monture (1) ou à l'élément intermédiaire ou aux éléments intermédiaires et, dans sa région intérieure, est relié à l'élément optique (7) par l'intermédiaire d'une liaison rigide transmettant les moments (12).

2. Sous-ensemble selon la revendication 1, **caractérisé en ce que** l'élément de joint comporte un anneau (4) en forme de membrane ou plusieurs segments d'anneau (15) en forme de membrane qui peuvent être assemblés en un anneau fermé en forme de membrane.

3. Sous-ensemble selon la revendication 1 ou 2, **caractérisé en ce que** l'élément de joint (4) est pourvu, sur la périphérie intérieure, de pattes (6) sur lesquelles l'élément optique (7) s'appuie et par l'intermédiaire desquelles est établie la liaison rigide transmettant les moments (12).

4. Sous-ensemble selon l'une des revendications 1 à 3, **caractérisé en ce que** l'élément de joint (4) est fait d'une tôle mince élastique à la façon d'un ressort.

5. Sous-ensemble selon l'une des revendications 1 à 4, **caractérisé en ce que** la liaison (12) est réalisée par sûreté de forme ou par action de force, par exemple par soudage, soudage à la soudure tendre, collage ou serrage.

6. Sous-ensemble selon l'une des revendications 1 à 5, **caractérisé en ce que**, dans la région périphérique extérieure dans laquelle il est relié au cadre (1) ou à un ou plusieurs éléments intermédiaires, l'élément de joint (4) comporte des fentes (8) qui s'étendent au moins approximativement dans une direction radiale ou tangentielle pour assurer le découplage de la déformation.

7. Sous-ensemble selon la revendication 6, **caractérisé en ce que**, dans le cas où l'élément de joint est formé d'un anneau en forme de membrane (4), les fentes (8) s'étendent en alternance à partir de la périphérie extérieure et de la périphérie intérieure.

8. Sous-ensemble selon l'une des revendications 1 à 7, **caractérisé en ce que** l'élément de joint (4) est pourvu de poches de décharge (9), au moins dans la région dans laquelle il est relié à la monture (1) ou à un ou plusieurs éléments intermédiaires.

9. Sous-ensemble selon l'une des revendications 1 à 8, **caractérisé en ce que**, dans la région de la liaison, la monture (1) ou un élément intermédiaire auquel l'élément de joint (4) est relié comporte un profil d'appui (3) qui correspond à la ligne de flexion de l'élément de joint.

10. Sous-ensemble l'une des revendications 1 à 9, **caractérisé en ce que** l'élément de joint (4), en particulier lorsqu'il comporte des pattes (6), est pourvu au moins partiellement d'une structure de grille (21) ou de peigne (20) dans la région de la liaison rigide transmettant les moments (12) qui est formée par collage ou par soudage à la soudure tendre.

11. Sous-ensemble selon l'une des revendications 3 à 10, **caractérisé en ce que** les pattes (6) sont structurées sur leurs surfaces (19, 20).

12. Sous-ensemble selon l'une des revendications 3 à 11, **caractérisé en ce que** les pattes (6) ont des largeurs différentes sur leur longueur.

13. Sous-ensemble selon l'une des revendications 1 à 12, **caractérisé en ce que** l'élément de joint (4) est pourvu, par intégration ou par application, d'une matière intelligente (matière smart, par exemple éléments à mémoire de forme ou piézo-électriques).

14. Sous-ensemble selon l'une des revendications 1 à 12, **caractérisé en ce que** l'élément de joint (4) est réalisé en une matière possédant des propriétés superélastiques.

15. Sous-ensemble selon l'une des revendications 1 à 14, **caractérisé en ce que** la monture (1), ou un élément relié à la monture, est reliée à une bague de support (17) sur laquelle font saillie des éléments (chevilles 16) disposés dans la bague de support (17), qui sont reliés à l'élément optique (7) par leurs extrémités libres de telle manière qu'il s'établisse un accroissement de la rigidité perpendiculairement à l'axe optique (direction z) et/ou selon la direction de cet axe.

16. Sous-ensemble selon la revendication 15, **caractérisé en ce que** les éléments (chevilles 16) sont collés dans des alésages de la bague de support (17) ou fixés par une autre technique de liaison agissant par sûreté de forme ou par action de force.

17. Sous-ensemble selon l'une des revendications 1 à 16, **caractérisé en ce que** l'élément optique (7) est tenu par un deuxième élément de joint (4') en forme de membrane, disposé sur le côté qui est éloigné de la liaison (12) avec le premier élément de joint (4), par une liaison rigide transmettant les moments (12').

18. Sous-ensemble selon l'une des revendications 1 à 17, **caractérisé en ce que** la monture (1) est pourvue d'un épaulement de centrage (5) pour l'élément de joint (4).

19. Procédé pour assembler un élément optique à une monture ou à un élément intermédiaire relié à la monture, **caractérisé en ce qu'**un élément de joint (4) en forme de membrane est fixé à la monture (1) après quoi l'élément optique (7) est posé sur l'élément de joint (4) et aligné sur l'élément de joint (4) par une opération d'alignement du joint, après quoi l'élément optique (7) est fixé sur l'élément de joint (4) par une liaison rigide transmettant les moments (12).

20. Procédé selon la revendication 19, **caractérisé en ce que**, pour le montage, la monture (1) est serrée sur une contre-bride rigide (11).
